(19) Europäisches Patentamt
European Patent Office
Office européen des brevets

(11) **EP 1 782 027 B1**

(12) **FASCICULE DE BREVET EUROPEEN**

(45) Date de publication et mention de la délivrance du brevet:
**08.10.2008 Bulletin 2008/41**

(21) Numéro de dépôt: **05776483.9**

(22) Date de dépôt: **13.06.2005**

(51) Int Cl.:
***G01J 11/00*** *(2006.01)*

(86) Numéro de dépôt international:
**PCT/FR2005/050437**

(87) Numéro de publication internationale:
**WO 2006/003338 (12.01.2006 Gazette 2006/02)**

(54) **DISPOSITIF DE MESURE DE PROFIL D'IMPULSIONS**

IMPULSPROFIL-MESSEINRICHTUNG

PULSE PROFILE MEASUREMENT DEVICE

(84) Etats contractants désignés:
**AT BE BG CH CY CZ DE DK EE ES FI FR GB GR HU IE IS IT LI LT LU MC NL PL PT RO SE SI SK TR**

(30) Priorité: **15.06.2004 FR 0451277**
**28.06.2004 FR 0451346**

(43) Date de publication de la demande:
**09.05.2007 Bulletin 2007/19**

(73) Titulaire: **COMMISSARIAT A L'ENERGIE ATOMIQUE**
**75015 Paris (FR)**

(72) Inventeur: **JOLLY, Alain**
**F-33510 ANDERNOS (FR)**

(74) Mandataire: **Poulin, Gérard et al**
**Brevatome**
**3, rue du Docteur Lancereaux**
**75008 Paris (FR)**

(56) Documents cités:
**US-A- 5 555 119      US-B1- 6 738 133**

- **DENG K-L ET AL: "SINGLE-SHOT OPTICAL SAMPLING OSCILLOSCOPE FOR ULTRAFAST OPTICAL WAVEFORMS" IEEE PHOTONICS TECHNOLOGY LETTERS, IEEE INC. NEW YORK, US, vol. 10, no. 3, mars 1998 (1998-03), pages 397-399, XP000740683 ISSN: 1041-1135**

**Description**

<u>Domaine technique et art antérieur</u>

L'invention concerne un dispositif de mesure de profil d'impulsions monocoup de très courte durée.

L'invention s'applique à la mesure d'impulsions laser de durées comprises entre quelques picosecondes et quelques dizaines de nanosecondes, dans des bandes de fréquences analogiques typiques comprises, compte tenu de la technologie actuelle des fibres optiques et composants associés, entre 10 GHz et 300 GHz.

L'invention s'applique également à la mesure d'impulsions électriques monocoup de durées comprises entre quelques dizaines de picosecondes et quelques dizaines de nanosecondes, dans des bandes de fréquences analogiques comprises, compte tenu de la technologie actuelle des modulateurs électro-optiques, entre 10 GHz et 100 GHz.

Avantageusement l'invention s'applique également à la mesure d'impulsions optiques et électriques à faible taux de répétition.

La mesure du profil d'impulsions monocoup de courte durée est généralement difficile et requiert une instrumentation onéreuse. Selon les performances recherchées, différents types d'instruments sont utilisés, tels que, par exemple :

- les oscilloscopes électriques à échantillonnage monocoup, pour des impulsions dont les bandes de fréquences analogiques typiques varient, par exemple, de 0 à 7 GHz (la technologie est alors celle des convertisseurs «Flash»),
- les caméras à balayage de fente (caméras CBF) pour des impulsions dont les bandes de fréquences analogiques varient typiquement de quelques GHz à 100 GHz (la technologie utilisée est celle des tubes électroniques à vide, avec déflexion latérale linéarisée permettant de restituer l'axe des temps) ; les caméras à balayage de fente sont des équipements complexes et onéreux qui nécessitent d'être fréquemment recalibrés, à faible sensibilité optique et dont la sensibilité aux perturbations de l'environnement est importante,
- les autocorrélateurs pour des impulsions dont les bandes de fréquences analogiques typiques varient de quelques centaines de GHz à plusieurs dizaines de THz (ces équipements ne fournissent en fait qu'une mesure relative de la durée de l'impulsion, laquelle mesure est obtenue en tenant compte d'hypothèses sur la forme du profil) ; la technologie utilisée est celle de l'optique non linéaire avec mise en oeuvre d'une conversion temps/espace couplée à une analyse d'image et un traitement de signal.

Comparativement aux dispositifs de mesure d'impulsion monocoup de l'art connu, le dispositif de mesure de l'invention est une combinaison optimale de moyens simples et originaux qui permettent d'étendre de façon très significative les bandes de fréquences analogiques des impulsions mesurées.

Deng K-L ("Single-shot optical sampling oscilloscope for ultrafast optical waveforms", IEEE Photonics Technology Letters, Vol.10, No.3, pp.397-399, Mars 1998) décrit un dispositif de mesure d'impulsions optique monocoup comprenant des moyens de réplication des impulsions, sous la forme d'une cascade d'étages de type Mach-Zehnder. Chaque étage comporte un diviseur 3dB et sur l'une des branches de sortie, un rétard. Un amplificateur optique à semiconducteur est placé en sortie des moyens de réplication. Cet amplificateur permet de réduire les pertes subies par les impulsions au sein des moyens de réplication avant qu'elles pénètrent dans l'échantilloneur optique.

<u>Exposé de l'invention</u>

En effet, l'invention concerne un dispositif de mesure de profil d'impulsions optiques monocoup ou à faible taux de répétition comme défini dans la revendication 1

Selon un exemple de l'invention, l'échantillonneur optique est une cellule de Kerr qui comprend un milieu actif à effet Kerr placé entre deux polariseurs croisés.

Selon une caractéristique supplémentaire de l'invention, le dispositif de mesure comprend un dispositif interférométrique placé en sortie de l'échantillonneur optique pour réduire la largeur des échantillons optiques.

Selon un mode de réalisation préférentiel de l'invention, les moyens pour créer une série d'impulsions répliques de l'impulsion optique initiale comprennent un coupleur à quatre ports et un guide d'onde, par exemple une fibre optique monomode, rebouclé sur le coupleur.

L'invention concerne également un dispositif de mesure de profil d'impulsions électriques monocoup ou à faible taux de répétition, caractérisé en ce qu'il comprend un modulateur électro-optique en série avec un dispositif de mesure de profil d'impulsions optiques selon l'invention.

Le dispositif de mesure d'impulsions optiques selon l'invention couvre des bandes de fréquence actuellement inaccessibles aux oscilloscopes connus qui mesurent les impulsions optiques monocoup. Seules les caméras CBF donnent accès aux fréquences situées autour de 100 GHz, mais avec une dynamique de codage très inférieure à 8 bits, dynamique rendue accessible par le dispositif de l'invention.

**EP 1 782 027 B1**

Le dispositif de mesure d'impulsion selon l'invention possède une dynamique de codage étendue associée, par construction, à une très haute résolution temporelle. La dynamique est essentiellement limitée par le facteur de bruit de la boucle d'asservissement et par la conversion optique/électrique en sortie. La fonction de transfert de l'appareil utilise un processus saturable, ce qui permet de préserver une stabilité optimale. Cela n'est pas le cas dans les mécanismes de conversion non linéaire du type « amplification paramétrique » ou « conversion de fréquence optique », ou encore dans la configuration de type « autocorrélateur ».

Selon l'invention, la sensibilité de mesure est très élevée. A résolution temporelle identique, on peut citer une sensibilité supérieure de plusieurs décades à celle des caméras CBF. On peut aussi comparer de manière avantageuse les performances du dispositif selon l'invention avec celles des autocorrélateurs, dans lesquels le processus de conversion optique non linéaire est incompatible avec la conversion de signaux optiques à bas flux.

La mise en oeuvre du dispositif de l'invention à l'aide d'une boucle fibrée couplée à un absorbant saturable présente l'intérêt d'une grande simplicité technologique, avec un nombre très réduit de composants actifs. Une conséquence de cette simplicité au regard des performances accessibles est la possibilité d'une réalisation à un coût réduit. Une comparaison très avantageuse peut être réalisée, de ce point de vue, avec les oscilloscopes « tout optique » pour applications dans le domaine des Télécommunications et avec les caméras CBF. Les besoins en traitement de signal et en calibration, indispensables à l'exploitation des mesures, s'en trouvent réduits. Si l'on se réfère aux contraintes de mise en oeuvre d'une caméra CBF, dont une re-calibration périodique est indispensable, le dispositif de l'invention bénéficie d'un avantage important en terme d'utilisation.

Le dispositif de l'invention est particulièrement robuste. En effet, tous les composants optiques critiques de la fonction d'échantillonnage sont préférentiellement fibrés, issus de technologies éprouvées dans les secteurs des télécommunications et des lasers. De même, la partie électronique située en aval du dispositif est constituée de composants qui sont spécifiés dans des bandes de fréquences situées bien en deçà des fréquences analogiques élevées de la partie optique. Les composants les plus rapides sont, par exemple, les photodiodes de conversion électrique/optique, qui fonctionnent naturellement en mode intégrateur et dont le temps de réponse doit simplement demeurer inférieur à $\tau$.

Dans le cas de la mesure d'impulsions électriques, le dispositif de l'invention permet avantageusement une analyse de profils d'impulsions dans une large gamme de fréquences. Malgré la réduction de la bande passante analogique qui résulte de l'insertion d'un convertisseur électro-optique en entrée, le dispositif de mesure d'impulsions électriques selon l'invention offre des performances très supérieures à celles des équipements connus tels que, par exemple, les caméras CBF dont la dynamique de codage est très limitée lorsqu'elles sont utilisées sur leurs bases de temps les plus rapides.

Le concept à la base du dispositif de mesure selon l'invention est très flexible et évolutif, car adaptable à une gamme étendue de compromis à optimiser au regard des performances de mesure recherchées.

Brève description des figures

D'autres caractéristiques et avantages de l'invention apparaîtront à la lecture d'un mode de réalisation préférentiel de l'invention fait en référence aux figures jointes parmi lesquelles :

- la figure 1 représente un dispositif de mesure d'impulsion optique monocoup selon l'invention ;
- les figures 2A-2D représentent des diagrammes temporels qui illustrent le fonctionnement du dispositif de mesure représenté en figure 1 ;
- la figure 3 représente une première variante d'un circuit particulier du dispositif de mesure selon l'invention ;
- la figure 4 représente une deuxième variante du circuit particulier dont une première variante est représenté en figure 3 ;
- les figures 5A-5C représentent des diagrammes temporels qui illustrent le fonctionnement du circuit représenté en figure 4 ;
- la figure 6 représente un perfectionnement du dispositif de mesure représenté en figure 1 ;
- la figure 7 représente une vue de détail d'un circuit du dispositif de mesure selon le perfectionnement représenté en figure 6 ;
- les figures 8A-8B représentent des diagrammes temporels qui illustrent le fonctionnement du circuit représenté en figure 7 ;
- la figure 9 représente un autre mode de réalisation du dispositif de mesure selon l'invention ;
- la figure 10 représente un perfectionnement du dispositif de mesure représenté en figure 9 ;
- la figure 11 représente un dispositif de mesure d'impulsion électrique monocoup selon l'invention.

Sur toutes les figures, les mêmes repères désignent les mêmes éléments.

3

Description détaillée de modes de mise en oeuvre de l'invention

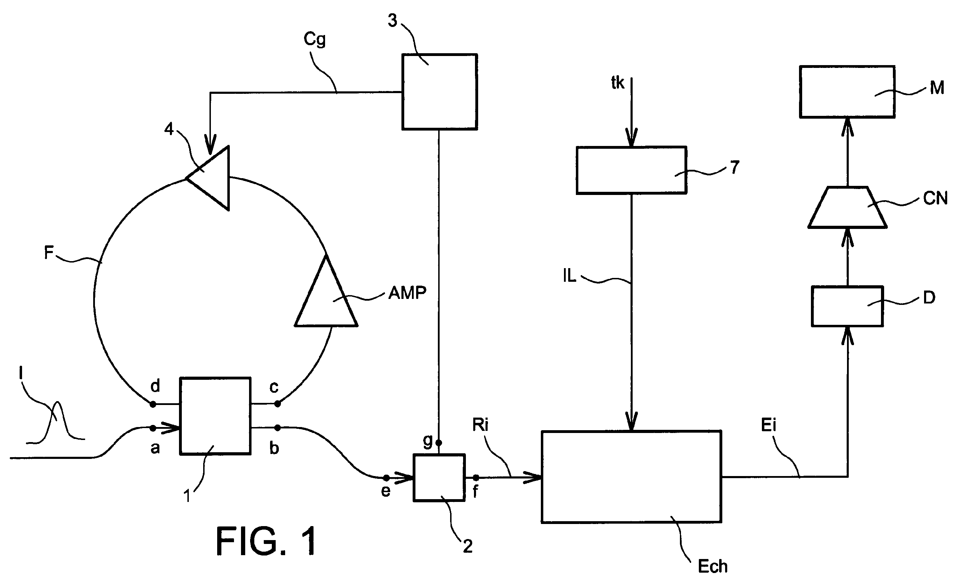

La figure 1 représente un dispositif de mesure d'impulsion optique selon le mode de réalisation préférentiel de l'invention.

Le dispositif comprend un coupleur à quatre ports 1, une fibre optique monomode F, un coupleur à trois ports 2, un circuit de commande 3, un amplificateur isolé (amplification unidirectionnelle) AMP, un atténuateur électro-optique 4 pilotable de manière électronique (commande périodique) en série avec l'amplificateur AMP, une source 7 d'impulsions laser récurrentes et de très courte durée, un échantillonneur optique Ech, un détecteur D, un convertisseur analogique/numérique CN et une mémoire M. L'échantillonneur Ech fonctionne, dans le cas de la Figure 1, en mode « transmission ». Il faut cependant noter que l'invention concerne également un autre mode de réalisation où l'échantillonneur ECH travaille en mode « réflexion ».

La fibre optique F, de longueur L, est de type monomode afin d'éviter que des effets de dispersion de mode n'apparaissent, qui élargiraient les signaux impulsionnels qui se propagent. Le coupleur 1 a quatre ports a, b, c, d. Le port a constitue l'entrée du dispositif de mesure, le port b est relié à l'entrée du coupleur à trois ports 2, le port c est relié à l'entrée de l'amplificateur AMP via un premier tronçon de la fibre F et le port d est relié à la sortie de l'atténuateur 4 via un deuxième tronçon de la fibre F.

Le coupleur 1 à quatre ports est un coupleur directionnel qui fonctionne comme suit :

- un signal qui entre sur le port a est transmis pour une fraction de $\alpha$%, par exemple 5%, sur le port b et pour la fraction restante de $(1-\alpha)$%, par exemple 95%, sur le port c, et
- un signal qui entre sur le port d est transmis pour une fraction de $\alpha$% sur le port b et pour la fraction restante de $(1-\alpha)$% sur le port c.

Une impulsion laser initiale I qui entre dans le dispositif de mesure par le port a du coupleur 1 se scinde en conséquence en une première fraction d'impulsion ($\alpha$%) délivrée sur le port b et une deuxième fraction d'impulsion ($(1-\alpha)$%) délivrée sur le port c. La première fraction d'impulsion est dirigée vers le coupleur 2 et la deuxième fraction d'impulsion est rebouclée, via la fibre F, l'amplificateur AMP et l'atténuateur 4 sur le port d du coupleur 1. La vitesse v de propagation de la deuxième fraction d'impulsion sur la fibre F de longueur L définit un temps de boucle $\tau$ tel que :

$$\tau = L/v$$

Lorsqu'elle pénètre dans le port d, la deuxième fraction d'impulsion ainsi rebouclée est elle-même divisée en une troisième fraction d'impulsion ($\alpha$%) qui est délivrée sur le port b, vers le coupleur 2, et une quatrième fraction d'impulsion ($(1-\alpha)$%) qui est rebouclée sur le port d. A chaque tour de boucle d'une fraction d'impulsion, le coupleur 1 renvoie ainsi une fraction $\alpha$% de la puissance qu'il reçoit sur le port de sortie b et une fraction de $(1-\alpha)$% sur le port c.

Une impulsion laser initiale qui entre dans le dispositif de mesure par le port a du coupleur 1 est ainsi à l'origine d'une série d'impulsions répliques de l'impulsion initiale qui sont séparées les unes des autres de la durée $\tau$. Le taux de transmission de l'atténuateur 4 et le gain G de l'amplificateur AMP qui sont situés dans la boucle sont réglés de manière dynamique pour compenser les pertes de couplage, afin que la quantité $\alpha \times G$ soit typiquement comprise entre 0, 95 et 1 ($0, 9 < \alpha \times G < 1$). Un coefficient de calibration pris en compte après la conversion analogique-numérique permet de recaler en amplitude toutes les répliques, de manière électronique, de telle sorte que la condition élémentaire suivante soit alors réalisée :

$$\alpha \times G \approx 1 \qquad (1)$$

La relation (1) ci-dessus est obtenue à l'aide d'une boucle d'asservissement numérique. A cette fin, une fraction de chaque réplique est prélevée à l'aide du coupleur 2. Le coupleur 2 est un coupleur à trois ports e, f, g. Le port e est relié au port b du coupleur 1, le port f est relié à l'entrée du diviseur 5 et le port g est relié à l'entrée du circuit de commande 3. Un signal qui entre dans le coupleur 2 par le port e est divisé en une première fraction délivrée sur le port g et une deuxième fraction délivrée sur le port f. La fraction délivrée sur le port g peut représenter, par exemple, 3% du signal qui entre sur le port e. Cette première fraction du signal constitue le signal d'entrée du circuit de commande 3. Le circuit de commande 3 évalue l'amplitude de la fraction de signal qu'il reçoit sur son entrée et délivre en conséquence une commande d'atténuation Cg qui, appliquée à l'atténuateur 4, assure un gain de boucle compris entre 0,95 et 1 typiquement afin que toutes les répliques conservent des amplitudes voisines.

Les impulsions recueillies sur le port de sortie f du coupleur 2 constituent alors une suite d'impulsions répliques Ri (i=1, 2, ..., N) de période τ. Les impulsions répliques Ri sont transmises en entrée de l'échantillonneur optique Ech qui les échantillonne sous l'action des impulsions laser IL délivrées par la source d'impulsions laser 7. La source d'impulsions laser 7 est, préférentiellement, une source à blocage de modes qui fournit des impulsions laser de période To et de durée $T_{ML}$ très inférieure à τ ($T_{ML}$ « τ).

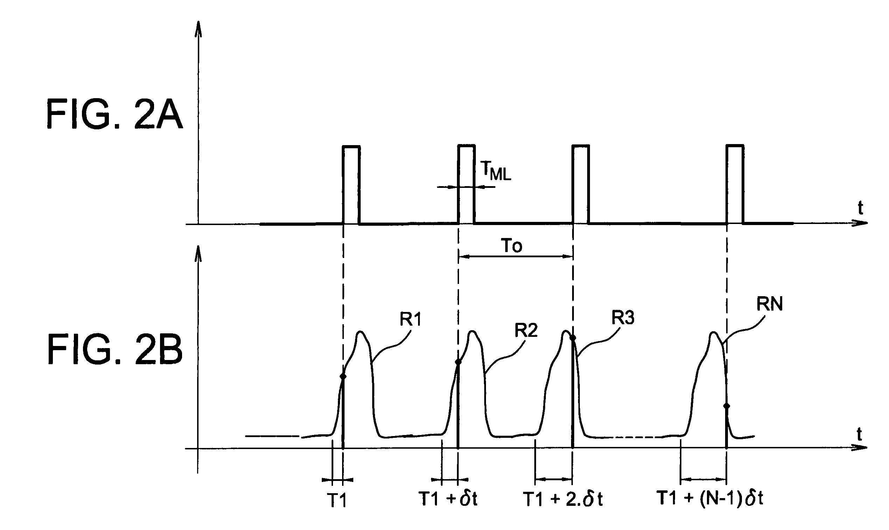

Les figures 2A-2D représentent des chronogrammes permettant d'illustrer l'échantillonnage des impulsions répliques.

La figure 2A illustre les impulsions de largeur $T_{ML}$ et de période To qui sont délivrées par la source laser 7.

La figure 2B représente une succession de répliques R1, R2, R3, ..., RN échantillonnées sur la base des impulsions représentées en figure 2A. La première réplique R1 est échantillonnée à une première position temporelle T1, la position temporelle T1 mesurant une durée qui sépare un instant qui marque le début de la réplique R1 et l'instant d'échantillonnage. Les répliques Ri de rang i supérieur à 1 (i>1) sont échantillonnées aux positions temporelles respectives T1+(i-1)δt. Ainsi l'instant d'échantillonnage glisse-t-il de manière progressive de la quantité δt à l'intérieur du profil des répliques successives. Ce principe d'échantillonnage s'apparente à celui de l'échantillonnage séquentiel électronique utilisé pour des impulsions récurrentes. La configuration mise en oeuvre dans le cadre de la mesure d'impulsion optique selon l'invention est cependant très différente de celle mise en oeuvre dans le cadre de la mesure d'impulsions électriques récurrentes. Le procédé de l'invention présente en effet l'avantage de restituer un profil vrai d'impulsion et non pas un profil temporel moyenné comme c'est le cas pour la mesure d'impulsions électriques récurrentes.

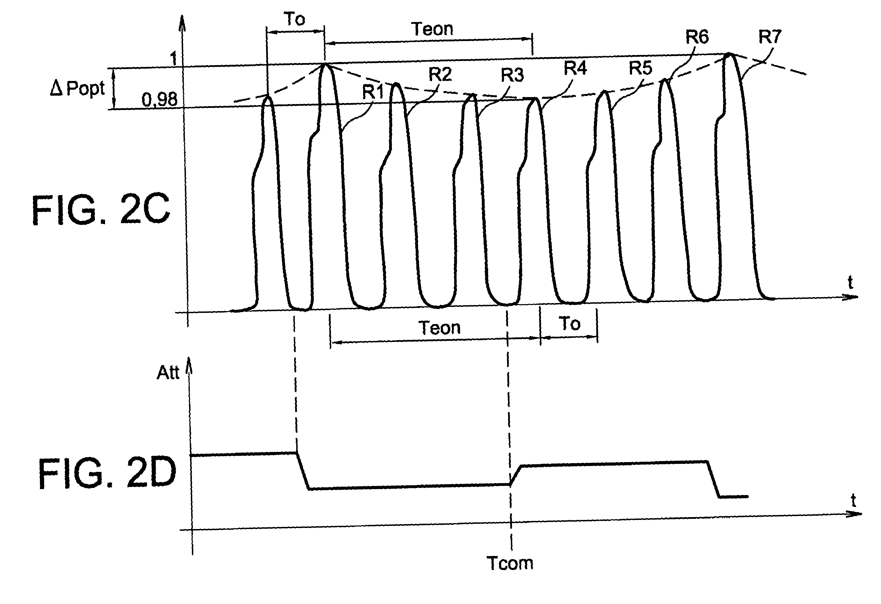

La Figure 2C représente un exemple de succession de répliques dont l'enveloppe décrit l'évolution des intensités crête des répliques au cours du temps, dans le cas particulier où l'électronique d'asservissement active de manière périodique l'atténuateur 4. Dans cet exemple, la période d'asservissement Teon est égale au triple de la période To. Les variations d'intensité crête ΔPopt sont ici inférieures à 10% et sont périodiques. Les variations de l'enveloppe à l'intérieur d'une période Teon donnée sont déterminées par la valeur de α x G, et présentent une forme exponentielle pour une valeur constante α x G < 1. A la fin de la période d'asservissement suivante, le fonctionnement du système fait que l'intensité crête de la réplique R7 reprend la même valeur que celle de la réplique R1 dans la période d'asservissement précédente. Ainsi, un coefficient de calibration est associé à chacune des répliques R1 - R7, et la prise en compte de ce facteur de calibration après la conversion analogique-numérique permet de se ramener à la condition équivalente (1).

La Figure 2D représente l'évolution de la valeur de l'atténuation att (rapport du niveau du signal en sortie de l'atténuateur sur le niveau du signal en entrée de l'atténuateur) pilotée par l'asservissement électronique, via la commande Cg. L'atténuation est constante sur une période To, et commutée à une valeur différente lors de la période suivante, afin que la perte d'intensité ΔPopt soit compensée avec précision.

D'autres modes de fonctionnement en asservissement sont également possibles qui ne seront pas détaillés ici.

Les échantillons Ei (i = 1, 2, ..., N) délivrés par l'échantillonneur optique Ech sont transmis à un détecteur D, par exemple une photodiode. Le détecteur D peut fonctionner, par exemple, dans des bandes de fréquences analogiques comprises entre 10Ghz et 60Ghz, comme l'autorisent actuellement les technologies de télécommunications. La conversion optique/électrique mise en oeuvre par le détecteur D s'opère en mode intégrateur. Le mode intégrateur consiste à assimiler l'amplitude d'un échantillon optique donné à la valeur intégrée dans le temps de la réponse électrique du détecteur. Les seules erreurs commises, à corriger éventuellement, sont alors celles qui résultent des effets de désaturation du détecteur, du décalage de la ligne de base induit par un effet d'empilement des impulsions électriques successives, etc.

Le détecteur D délivre des échantillons électriques qui sont transmis au convertisseur analogique-numérique CN qui code le niveau des signaux qu'il reçoit. Le codage peut être, par exemple, un codage sur 8 ou 10 bits. Le temps de codage n'est pas critique. Il est seulement limité par la valeur de τ. Les données numériques délivrées par le convertisseur analogique-numérique CN sont alors transmises à la mémoire M dont le temps d'accès est au moins égal à τ.

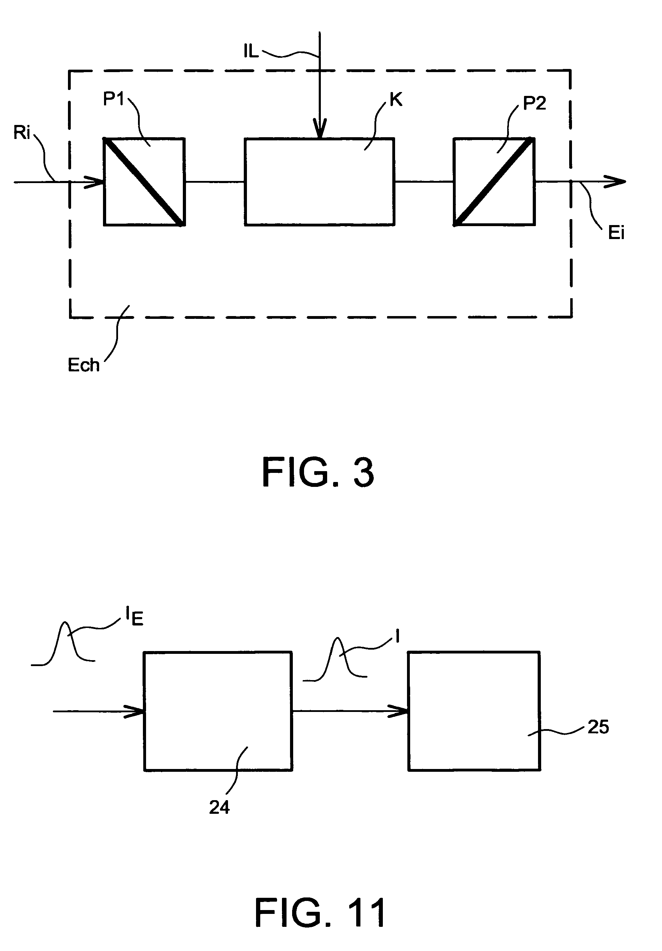

La figure 3 représente l'échantillonneur optique Ech selon une première variante de l'invention.

L'échantillonneur optique Ech est une cellule de Kerr. La cellule de Kerr comprend un milieu actif à effet Kerr K placé entre deux polariseurs croisés P1, P2. Lors de l'application d'une impulsion laser IL délivrée par la source 7, le milieu K présente une biréfrigence transitoire suffisante pour faire passer le dispositif d'un état bloqué (milieu non dépolarisant placé entre deux polariseurs croisés) à un état passant (transmission de la composante de polarisation optique dans le plan du polariseur de sortie).

L'échantillonneur optique sous la forme d'une cellule de Kerr présente une excellente résolution temporelle. Il est en effet possible de délivrer des échantillons optiques dont la largeur est de l'ordre de deux cents femtosecondes.

Le milieu actif à effet Kerr peut être, par exemple, un liquide du type $CS_2$ nécessitant un conditionnement en enceinte étanche. Le milieu actif à effet Kerr peut également être un milieu solide à base de verre qui nécessite alors une plus forte intensité laser en sortie de la source 7.

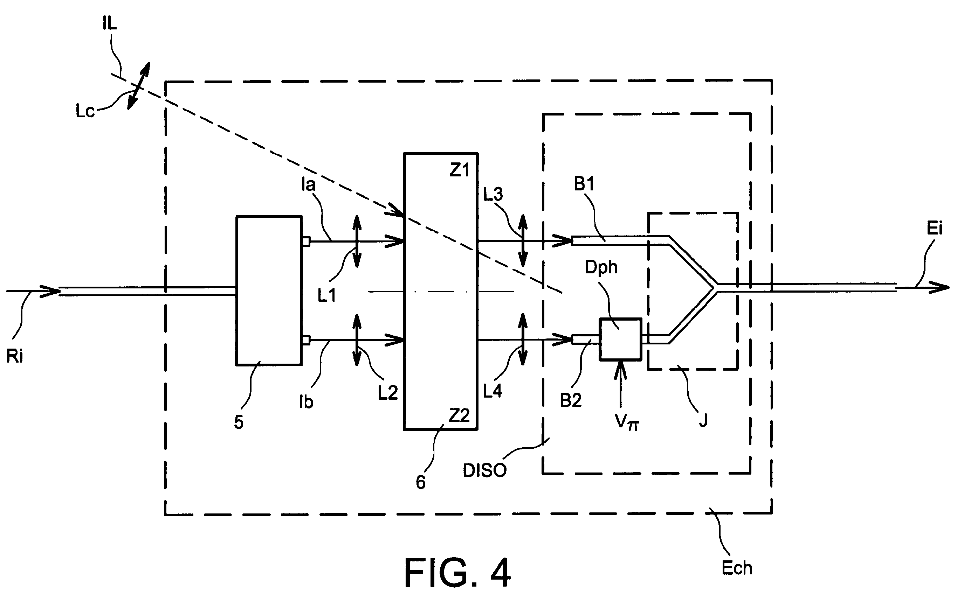

La figure 4 représente l'échantillonneur optique Ech selon une deuxième variante de l'invention.

L'échantillonneur Ech comprend alors un diviseur par deux 5, un absorbant saturable rapide 6, un dispositif interférométrique de soustraction optique DISO et des lentilles de collimation L1, L2, L3, L4. Le dispositif interférométrique de soustraction optique DISO comprend deux bras d'entrée B1, B2, le bras B2 étant muni d'un déphaseur Dph, et une jonction de recombinaison J à deux entrées et une sortie. L'entrée et la sortie de l'échantillonneur sont respectivement l'entrée du diviseur par deux 5 et la sortie de la jonction J. Les bras B1 et B2 et la jonction J sont réalisés à l'aide de tout type de guide d'ondes optiques, par exemple des fibres optiques.

Une impulsion réplique Ri reçue en entrée de l'échantillonneur Ech est divisée en une première fraction d'impulsion Ia et en une deuxième fraction d'impulsion Ib d'amplitude sensiblement identique à l'amplitude de la fraction d'impulsion Ia. La première fraction d'impulsion Ia est transmise vers une première zone Z1 de l'absorbant saturable via une première lentille de collimation L1 et la deuxième fraction d'impulsion Ib est transmise vers une deuxième zone Z2 de l'absorbant saturable via une deuxième lentille de collimation L2.

Le fonctionnement d'un absorbant saturable est basé sur le phénomène de saturation de l'absorption. Des signaux de faible intensité qui traversent un absorbant saturable subissent l'absorption intrinsèque du milieu absorbant et sont, en conséquence, absorbés partiellement. Par contre, des signaux de fortes intensités blanchissent le milieu absorbant qu'ils traversent jusqu'à réduire l'absorption de celui-ci à une valeur sensiblement inférieure à celle de l'absorption initiale. Des signaux de fortes intensités peuvent alors être transmis partiellement.

D'un point de vue mathématique, la caractéristique de transfert d'un absorbant saturable s'exprime par la relation suivante :

$$A(\Phi) = \frac{A_o}{1 + \dfrac{\Phi}{\Phi_{sat}}} \qquad (3),$$

où

- A($\Phi$) est le coefficient d'absorption de l'absorbant en fonction de l'intensité $\Phi$ du signal qui éclaire l'absorbant,
- Ao est le coefficient d'atténuation de l'absorbant en absence d'éclairement, et
- $\Phi_{sat}$ est l'intensité de saturation propre de l'absorbant (W/cm$^2$).

Dans le cadre de l'invention, la zone Z1 est éclairée par les fractions d'impulsion Ia et par les impulsions IL alors que la zone Z2 est éclairée par les seules fractions d'impulsions Ib. La puissance crête P$_{ML}$ des impulsions IL issues de la source laser à blocage de modes 7 (source SML) est choisie pour saturer la transmission de l'absorbant de manière totale ou, du moins, très significative pendant les durées T$_{ML}$ des impulsions laser fournies par la source 7. Le faisceau des impulsions IL et le faisceau des fractions d'impulsions Ia ne sont pas colinéaires. Le faisceau des impulsions IL est collimaté sur la zone Z1 d'absorbant saturable, via une lentille de collimation Lc, selon un axe décalé de quelques degrés à quelques dizaines de degrés de l'axe selon lequel est collimaté le faisceau des fractions d'impulsion Ia. Le signal recueilli en sortie de la zone Z1 et qui est collimaté, via la lentille de collimation L3, sur l'entrée du bras B1 est alors constitué des seules fractions d'impulsions Ia qui ont traversé la zone Z1.

Pour une fraction d'impulsion Ia qui pénètre dans la zone Z1, la zone Z1 se comporte comme une porte d'échantillonnage qui travaille à la fréquence Fo de la source laser à blocage de modes (Fo=1/To). Le temps d'ouverture T$_{ech}$ de la porte d'échantillonnage est approximativement égal au temps de recouvrement T$_{sat}$ de l'absorbant saturable. Le temps de recouvrement T$_{sat}$ a une durée supérieure à la durée d'impulsion T$_{ML}$.

Les grandeurs $\tau$ et To sont reliées de façon que :

$$\tau = (To - \delta t) \qquad (2)$$

où $\delta$t représente un glissement temporel de l'instant d'échantillonnage entre deux tours de boucle (cf. figure 2B). Le taux d'échantillonnage du dispositif de mesure est alors égal à $\delta$t, qui est supérieur ou égal à T$_{sat}$, mais qui est très inférieur à la durée T$_I$ de l'impulsion d'entrée. Le nombre maximum d'échantillons qui peuvent être acquis est N tel que :

$$N = \tau / \delta t \qquad (3)$$

Le nombre N peut également s'écrire :

$$N = 1 / ((To/\tau)-1) \qquad (4)$$

L'absorbant saturable selon l'invention peut être réalisé selon plusieurs technologies différentes. Une solution liquide à base de colorants en matrice solide peut être envisagée, ou encore un absorbant saturable solide à base de nano-tubes de carbone ou à semi-conducteurs. Les absorbants solides de ce type actuellement les plus rapides présentent des temps de recouvrement $T_{sat}$ de l'ordre de 1 à 5 picosecondes. D'un point de vue spectral, l'absorbant saturable est également choisi, préférentiellement, pour être compatible avec un fonctionnement optique dans le proche infrarouge qui est une bande de fréquences utiles pour les lasers à base de Néodyme, d'Ytterbium ou d'Erbium.

Alors que la zone Z1 se comporte comme une porte d'échantillonnage, la zone Z2 présente une absorption de coefficient Ao. Le signal délivré par la zone Z2 est transmis, via la lentille de collimation L4, à l'entrée du bras B2.

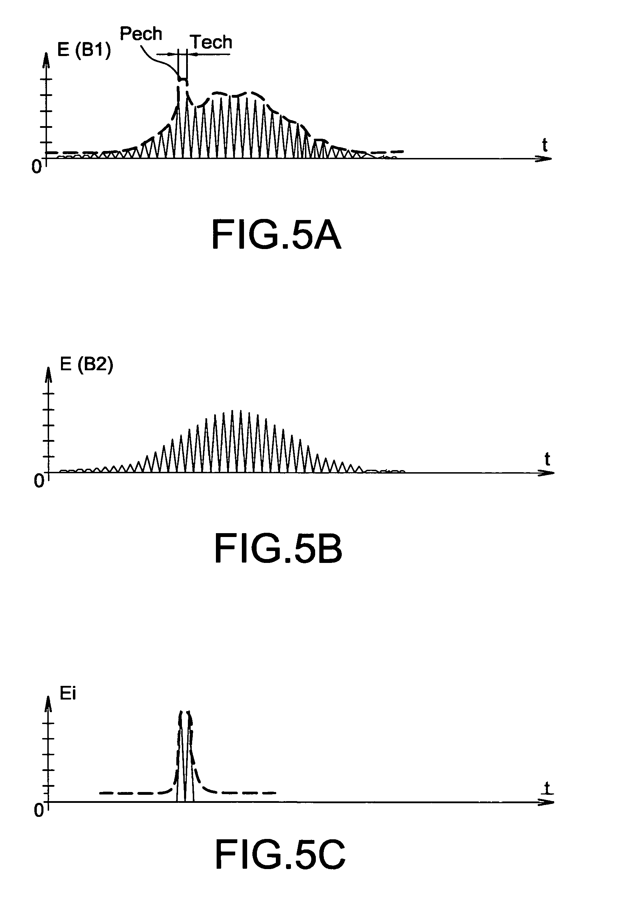

La figure 5A représente le signal échantillonné E(B1) recueilli en sortie de la zone Z1 et la figure 5B représente le signal E(B2) recueilli en sortie de la zone Z2. La signal E(B1) fait apparaître un pic d'échantillonnage $P_{ech}$ de largeur $T_{ech}$ au sein d'un signal qui reproduit, en l'atténuant, la fraction d'impulsion Ia. Le signal E(B2) reproduit, en l'atténuant, la fraction d'impulsion Ib.

Le bras B2 est équipé d'un déphaseur Dph commandé en tension. La tension $V_n$ appliquée au déphaseur Dph est ajustée de façon que le signal optique délivré en sortie du bras B1 soit en opposition de phase avec le signal délivré en sortie du bras B2. La jonction J qui somme les signaux délivrés par les bras B1 et B2 délivre alors un échantillon Ei de largeur $T_{ech}$ (cf. figure 5C).

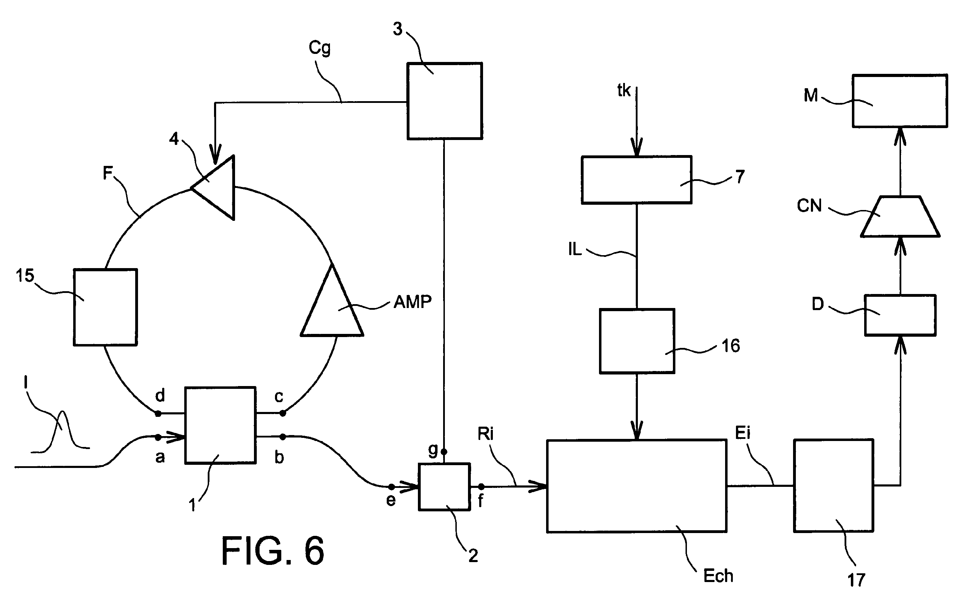

La figure 6 représente un perfectionnement du dispositif de mesure représenté en figure 1. Le perfectionnement de l'invention s'applique aussi bien dans le cas de la première variante que de la deuxième variante.

En plus des éléments représentés en figure 1, le dispositif de mesure comprend un compensateur de dispersion 15, une fenêtre optique 16 et un dispositif interférométrique de remise en forme 17. C'est pour des raisons de commodité que les trois dispositifs 15, 16 et 17 sont représentés sur la même figure. De fait, les dispositifs 15, 16 et 17 sont indépendants les uns des autres et peuvent être intégrés au dispositif de mesure ensemble ou séparément.

Le compensateur 15 est inséré dans la boucle entre la sortie de l'atténuateur 4 et le port d du coupleur 1. Il a pour fonction de compenser les effets de dispersion chromatique de la boucle qui, sinon, conduiraient à une déformation de l'impulsion qui se propage. Le compensateur 15 peut être, par exemple, un dispositif à réseau de Bragg de pas spatialement variable (« chirped » en langue anglaise) ou un tronçon de fibre dont le coefficient de dispersion est opposé au coefficient de dispersion des autres composants qui constituent la boucle.

La fenêtre optique 16 est placée entre la source 7 d'impulsions IL et l'échantillonneur Ech. Elle permet de définir une séquence d'échantillonnage élémentaire pendant une durée $\Delta T_E$ telle que :

$$\Delta T_E = N \times \delta t,$$

où

N est le nombre maximum d'échantillons qui peuvent être acquis (cf. équation (3)). La durée $T_I$ d'une impulsion optique doit alors être nécessairement inférieure à $\Delta T_E$. La porte optique 16 a pour fonction de définir une fenêtre temporelle pour l'application du train d'impulsions émises par la source 7. Cela permet d'éviter, entre autres, que l'absorbant saturable ne soit éclairé en permanence.

Selon un mode de réalisation particulier de la deuxième variante de l'invention (cas où l'échantillonneur optique comprend un diviseur et un absorbant saturable), le coupleur à quatre ports 1, le guide d'onde qui reboucle sur le coupleur à quatre ports, le coupleur à trois ports 2, l'atténuateur 4, l'amplificateur AMP et le diviseur 5 sont intégrés sur un substrat semi-conducteur à guides d'ondes implantés. L'atténuateur 4 et l'amplificateur AMP sont alors réalisés en technologie à semi-conducteur. Dans le cadre de ce mode de réalisation particulier, le compensateur 15 relatif au perfectionnement de l'invention est alors constitué d'un réseau de Bragg implanté sur le guide d'ondes.

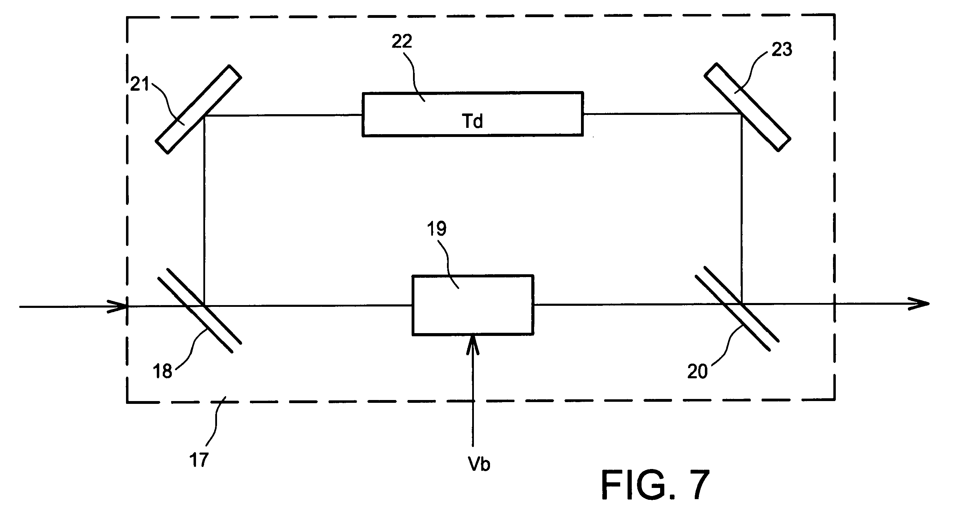

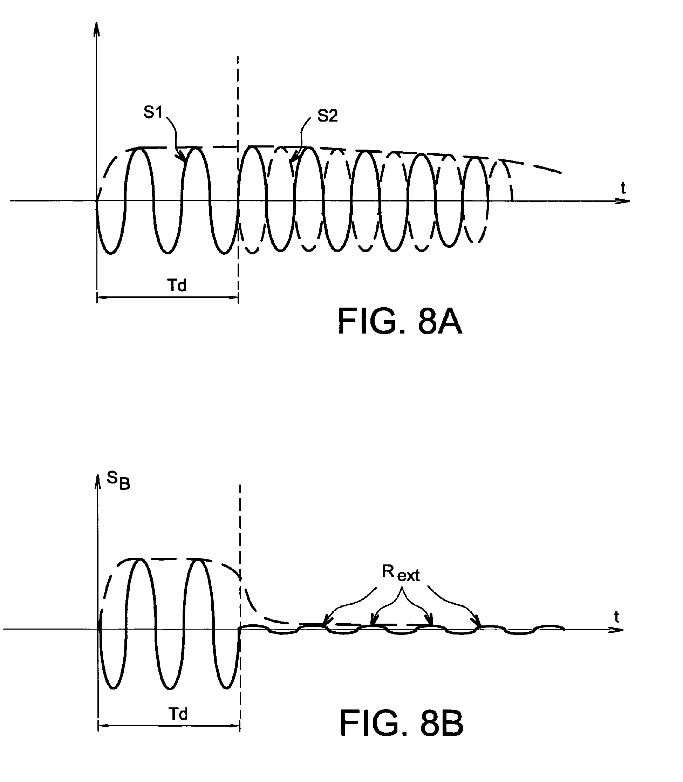

La figure 7 représente le dispositif interférométrique de remise en forme 17 dans le cas de la propagation en espace libre et les figures 8A et 8B représentent des diagrammes temporels qui illustrent le fonctionnement du dispositif interférométrique 17.

Le dispositif interférométrique 17 comprend un séparateur équilibré 18, un circuit à retard ajustable par polarisation externe 19, un combineur 20, deux miroirs 21, 23 et un circuit de retard fixe 22 (retard $T_d$). Le circuit à retard ajustable 19 est commandé par une tension de polarisation Vb. Un échantillon optique Ei délivré par l'échantillonneur optique Ech est transmis au séparateur équilibré 18. Le séparateur équilibré 18 transmet alors un premier sous-échantillon vers le circuit à retard ajustable par polarisation 19 dans une faible gamme de valeurs et un deuxième sous-échantillon vers le miroir 21. Le sous-échantillon qui est transmis sur le miroir 21 est réfléchi par ce dernier et transmis au deuxième miroir 23 à travers le circuit de retard 22. Le miroir 23 réfléchit le sous-échantillon qu'il reçoit et transmet celui-ci vers le combineur 20 qui reçoit, par ailleurs, le sous-échantillon d'impulsion transmis à travers le circuit à retard ajustable par polarisation 19. Le combineur 20 combine les deux sous-échantillons qu'il reçoit et transmet un signal d'échantillon remis en forme vers la photodiode 8.

Le circuit de retard 22 crée un retard Td entre le premier sous-échantillon et le deuxième sous-échantillon. Le deuxième sous-échantillon qui transite par le circuit de retard 22 est alors retardé de la quantité Td par rapport au premier sous-échantillon qui transite par le circuit à retard 19. Lorsqu'un signal d'échantillon arrive sur le séparateur 18, tant que la durée Td n'est pas écoulée, le signal délivré en sortie du dispositif interférométrique 17 n'est alors constitué que du premier sous-échantillon, celui qui transite par le circuit à retard ajustable 19. Lorsque la durée Td est écoulée, le signal délivré par le dispositif interférométrique 17 est constitué de la combinaison des premier et deuxième sous-échantillons (combineur 20). Le circuit à retard ajustable 19 est réglé à une tension de polarisation Vb égale à la tension demi-onde. Il s'en suit que les premier et deuxième sous-échantillons qui se combinent sont en opposition de phase et se détruisent par interférences. Le signal délivré par le dispositif interférométrique 17 est alors constitué d'un seul sous-échantillon de durée Td, durée au-delà de laquelle ne subsistent que de faibles résidus d'extinction $R_{ext}$ (résidus des interférences entre les premier et deuxième sous-échantillons). La figure 8B illustre le signal $S_B$ délivré par le dispositif interférométrique 17. La figure 8A illustre les différents signaux dont la combinaison conduit à l'obtention du signal $S_B$ illustré sur la figure 8B. Le signal S1 représente le premier sous-échantillon qui transite par le circuit 19 et le signal S2 représente le deuxième sous-échantillon qui transite par le circuit de retard 22.

Le dispositif interférométrique 17 est bien adapté aux profils à décroissance monotone de forme quasi-exponentielle, comme le sont les profils caractérisant la phase de recouvrement de la transmission des absorbants saturables (cf. figures 8A-8B).

La valeur du retard $T_d$ dépend de la différence de chemin optique entre les deux bras du dispositif interférométrique 17. Elle doit être généralement stable et précise. Dans le cas d'une réalisation en espace libre, un circuit de retard 22 peut être réalisé, par exemple, par une plaque d'indice et d'épaisseur calibrés placée entre les deux miroirs de renvoi 21 et 23. La longueur du milieu est alors choisie en fonction de la valeur souhaitée pour la durée $T_d$. Dans le cas d'une propagation guidée, le dispositif interférométrique 17 peut être intégré dans un composant à guides d'ondes implanté sur un substrat électro-optique, dans une technologie analogue, par exemple, à celle des modulateurs pour les télécommunications.

Comme cela a été mentionné précédemment, en l'absence de dispositif interférométrique 17, la résolution temporelle est limitée par le temps de recouvrement $T_{sat}$ de l'absorbant saturable qui doit alors être aussi court que possible. Avantageusement, le dispositif interférométrique 17 permet d'obtenir des durées de signal d'échantillonnage inférieures au temps de recouvrement $T_{sat}$. Il est alors possible, par exemple, de réduire la durée $T_{ech}$ d'une valeur $T_{sat}$ comprise entre 1 et 5ps à une valeur $T_d$ égale à quelques centaines de femtosecondes. La présence du dispositif interférométrique 17 permet ainsi d'améliorer significativement la limite de résolution temporelle des mesures et, partant, d'étendre le champ des domaines d'application de l'invention.

En dehors du fait que la mise en forme de la transition arrière doive être ajustée de manière très fine pour éliminer tout résidu de signal après la transition arrière, un autre phénomène est à prendre en compte : la mise en forme réalisée par le dispositif interférométrique modifie le bilan d'énergie. Un coefficient de calibration spécifique peut être utilisé pour tenir compte de la modification de la forme du signal. Une phase de calibration préalable est alors nécessaire.

Bien que non restrictifs, quelques chiffres caractéristiques permettent de quantifier les grandeurs de base et le domaine des performances accessibles dans le cadre de l'invention. Considérons le cas des sources SML standard, avec $T_{ML}$ = 100 à 200 fs, et un temps de boucle $\tau$ = 10 ns (soit L = 2 m) qui correspond à la valeur usuelle Fo = 100 MHz. Le nombre maximum d'échantillons se situe dans la gamme N = $10^2$ à $10^3$ échantillons, dans la mesure où l'amplificateur 4 de la boucle présente une puissance de saturation suffisante et où le taux de couplage en sortie de la zone Z1 reste faible. A titre d'exemple, une valeur de résolution $\delta$t=3ps sur le profil d'une impulsion de durée $T_I$ = 3 ns implique N = 1000 points. N est aussi la profondeur mémoire minimale nécessaire à la sauvegarde des échantillons acquis. En considérant une configuration complète incluant le dispositif interférométrique 17, il est possible d'évaluer les domaines d'application et de performances métrologiques recouverts par l'invention. Dans l'état de la technologie actuelle des composants optiques disponibles sur le marché, pour des impulsions dont la durée $T_I$ peut varier de quelques 10 picosecondes à quelques 10 nanosecondes, les valeurs suivantes donnent un aperçu du niveau des performances escomptées : une gamme de résolutions temporelles $\delta$t comprise entre 0,5 picoseconde et quelques picosecondes, une dynamique de codage en amplitude supérieure ou égale à 8 bits, un taux de répétition de la mesure du profil compris entre le monocoup et quelques gigahertz. Le codage sur 8 bits est compatible avec les performances des amplificateurs fibrés commerciaux et avec celles des photodiodes standard. Les meilleurs amplificateurs actuels présentent un facteur de bruit F = 4 à 5 dB. Les atténuateurs électro-optiques rapides existent dans différentes technologies intégrées sur guides d'ondes, avec des temps de réponse très inférieurs à la nanoseconde, donc compatibles avec le pilotage réalisé par l'électronique d'asservissement. Les photodiodes usuelles offrent une dynamique de l'ordre de 30 dB. Pour tous ces chiffres, des compromis sont à évaluer en fonction des besoins métrologiques. En ce qui concerne les besoins d'éclairement en régime picoseconde au niveau de l'absorbant saturable, par exemple dans le cas des nano-tubes de carbone dont le blanchiment total intervient aux alentours de 10 MW/cm$^2$, il faut aussi préciser qu'ils se situent tout à fait dans le domaine des fluences accessibles avec les technologies de sources SML existantes : à $F_0$=100 MHz et $P_{ML}$=10 MW crête/cm$^2$ correspondant à une énergie par impulsion laser d'échantillonnage de 10 pJ sur une section de 10 $\mu$m$^2$, soit une puissance moyenne de source égale à 1 mW.

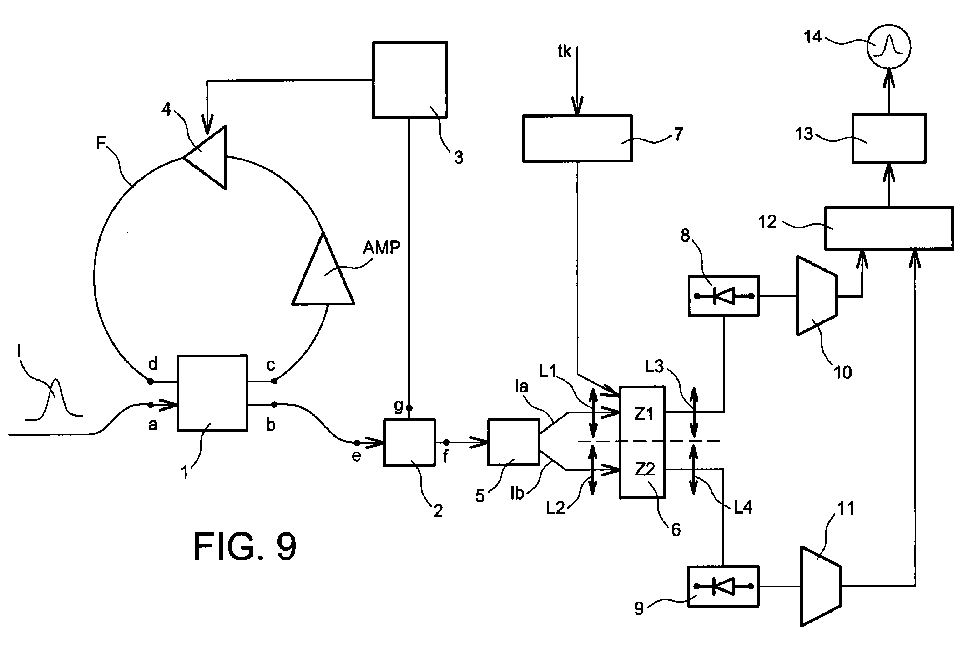

La figure 9 représente un autre mode de réalisation du dispositif de mesure selon l'invention.

Le dispositif de mesure comprend un coupleur à quatre ports 1, une fibre optique de type monomode F, un coupleur à trois ports 2, un circuit de commande 3, un atténuateur 4, un amplificateur AMP, un diviseur par deux 5, un absorbant saturable 6, une source 7 d'impulsions laser, deux détecteurs 8, 9, deux convertisseurs analogiques/numériques 10, 11, un circuit différentiel 12, une mémoire 13 et un dispositif d'affichage 14.

Les éléments 1, 2, 3, 4, AMP, 5, 6 et 7 sont reliés entre eux de la même façon que précédemment. Le signal délivré par la zone Z1 de l'absorbant est ici transmis à un premier détecteur 8 et le signal délivré par la zone Z2 est transmis à un deuxième détecteur 9. Les détecteurs 8 et 9 sont, préférentiellement, des photodiodes dont le temps de montée est compris, par exemple, entre une dizaine et quelques centaines de picosecondes. Les photodiodes 8, 9 sont placées derrière les zones Z1 et Z2 dans une configuration de couplage collimaté. Les photodiodes 8 et 9 peuvent fonctionner, par exemple, dans des bandes de fréquences analogiques comprises entre 10GHz et 60 GHz, comme l'autorisent actuellement les technologies des réseaux de télécommunications. Bien que cela ne soit pas indispensable, un transport intégral sur fibre monomode est possible entre les sorties des zones Z1 et Z2 et les détecteurs respectifs 8 et 9. Les contraintes de largeur de bande derrière la fonction d'échantillonnage sont en effet fortement relaxées et la conversion électrique/optique est opérée en mode intégrateur.

Les impulsions électriques délivrées par les photodiodes 8 et 9 sont transmises aux convertisseurs analogiques-numériques respectifs 10 et 11 qui codent numériquement le niveau des signaux qu'ils reçoivent. Le codage peut être, par exemple, un codage sur 8 à 10 bits. Le temps de codage n'est pas critique. Il est seulement limité par la valeur de $\tau$. Les données numérisées sont alors exploitées par une électronique de calcul (circuit différentiel 12) dont le rôle est de déterminer la différence $\Delta P$ entre le signal délivré par le convertisseur analogique-numérique 10 et le signal délivré par le convertisseur-analogique numérique 11. L'opération de différence précédemment réalisée de manière optique est ici réalisée de manière numérique.

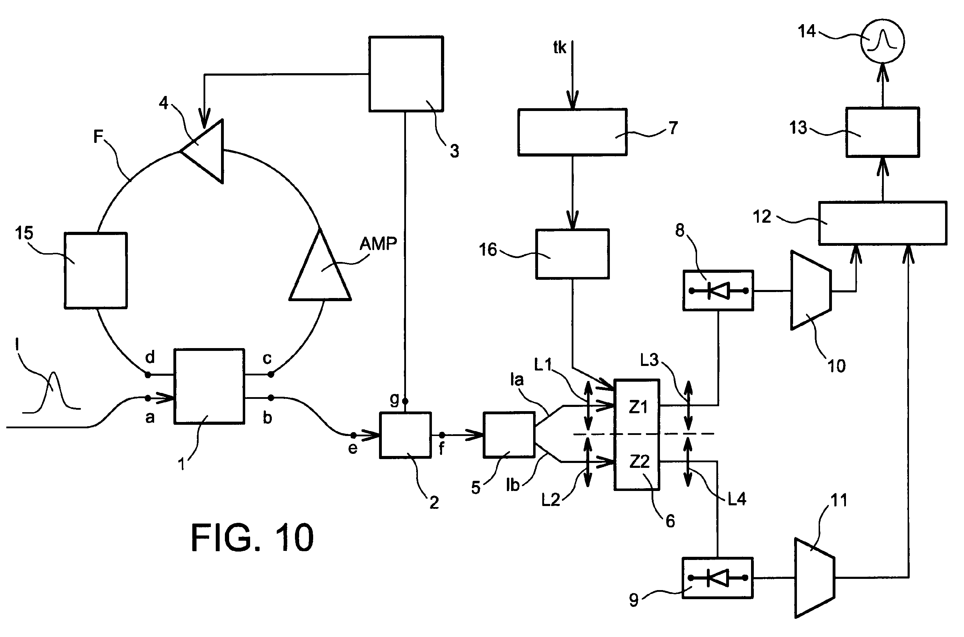

La figure 10 représente un perfectionnement du dispositif de mesure représenté en figure 9. En plus des éléments représentés en figure 9, le dispositif de mesure comprend un compensateur 15 et une fenêtre optique 16. Le compensateur 15 et la fenêtre optique 16 sont placés au même endroit que dans le perfectionnement représenté précédemment en figure 6 et présentent les mêmes avantages que précédemment.

Avantageusement, l'invention est applicable non seulement aux impulsions optiques mais également aux impulsions électriques. Il suffit alors de convertir en impulsion optique l'impulsion électrique qui doit être mesurée. Un modulateur électro-optique est alors placé sur le port a du coupleur 1 pour assurer la conversion. Le modulateur électro-optique peut être un modulateur à modulation directe ou un modulateur à modulation indirecte. Dans ce dernier cas, qui est celui qui autorise les plus grandes bandes passantes, le modulateur est alimenté à son entrée par une source laser continue de faible puissance. Dans le cas d'une modulation directe, le modulateur peut être, par exemple, une diode. Dans le cas de la mesure d'impulsions électriques, une certaine dégradation des performances fréquentielles est cependant à considérer, la fonction de transfert du modulateur électro-optique intervenant comme un facteur limitatif en termes de bande passante analogique du dispositif. Par contre, la résolution temporelle de l'échantillonnage est conservée.

Le modulateur électro-optique peut être, par exemple, un modulateur issu des technologies à électro-absorbants ou à polymères ou encore un modulateur à ondes progressives. La figure 11 illustre un dispositif de mesure d'impulsion électrique selon l'invention. Le dispositif comprend un modulateur électro-optique 24 en série avec un dispositif de mesure de profil d'impulsions optiques selon l'invention 25. Le modulateur électro-optique 24 convertit une impulsion électrique $I_E$ en une impulsion optique I.

## Revendications

1. Dispositif de mesure de profil d'impulsions optiques monocoup ou à faible taux de répétition, comprenant des moyens de réplication(1, F) pour créer, à partir d'une impulsion optique initiale (I), une série d'impulsions répliques (Ri) de l'impulsion optique initiale et de période $\tau$, des moyens d'asservissement (2, 3, 4) pour régler les amplitudes des impulsions répliques (Ri) à des valeurs sensiblement identiques les unes aux autres, des moyens d'échantillonnage (7, Ech) des impulsions répliques (Ri) pour délivrer des échantillons optiques (Ei) à partir des impulsions répliques (Ri) et des moyens de détection (D) pour former un signal électrique à partir des échantillons optiques (Ei) délivrés par les moyens d'échantillonnage (7, Ech), les moyens d'échantillonnage comprenant une source laser (7) apte à émettre des impulsions laser (IL) de fréquence 1/To et de durée ($T_{ML}$) très sensiblement inférieure à la durée de l'impulsion optique initiale, la période τ des impulsions répliques et la période To des impulsions laser étant reliées par la relation :

$$\tau = To - \delta t,$$

où
δt est un glissement temporel de durée très sensiblement inférieure à la durée de l'impulsion optique initiale, et un échantillonneur optique (Ech) éclairé par les impulsions répliques (Ri) et par les impulsions laser (IL), le dispositif étant **caractérisé en ce que**
lesdits moyens de réplication comprennent une boucle en fibre optique et un amplificateur (AMP) dans la boucle, ledit échantillonneur optique (Ech) comprend un diviseur (5) pour diviser une impulsion réplique (Ri) en une première fraction d'impulsion réplique (Ia) et en une deuxième fraction d'impulsion réplique (Ib), un absorbant saturable (6) comprenant une première zone (Z1) et une deuxième zone (Z2) éclairées, respectivement, par les première et deuxième fractions d'impulsion réplique, la première zone (Z1) étant rendue sensiblement transparente sous l'effet des impulsions laser (IL) et un dispositif interférométrique de soustraction optique (DISO) apte à délivrer un échantillon optique (Ei) comme résultat de la différence entre un signal échantillonné délivré en sortie de la première zone (Z1) et un signal délivré en sortie de la deuxième zone (Z2).

2. Dispositif selon la revendication 1, **caractérisé en ce que** le dispositif interférométrique de soustraction optique (DISO) comprend un premier bras (B1) ayant une entrée pour recueillir le signal échantillonné délivré en sortie de la première zone (Z1), un deuxième bras (B2) pour recueillir le signal délivré en sortie de la deuxième zone (Z2), un déphaseur (Dph), placé en série sur le deuxième bras, pour établir un déphasage de n entre le signal optique délivré en sortie du premier bras (B1) et le signal optique délivré en sortie du deuxième bras (B2) et une jonction (J) à deux entrées et une sortie qui recueille sur une première entrée le signal délivré en sortie du premier bras (B1) et sur une deuxième entrée le signal délivré en sortie du deuxième bras (B2) et qui délivre l'échantillon optique (Ei) sur sa sortie.

3. Dispositif selon l'une quelconque des revendications 1 ou 2, **caractérisé en ce que** l'absorbant saturable est une solution liquide à base de colorants.

4. Dispositif selon l'une quelconque des revendications 1 ou 2, **caractérisé en ce que** l'absorbant saturable comprend des nano-tubes de carbone.

5. Dispositif selon l'une quelconque des revendications 1 ou 2, **caractérisé en ce que** l'absorbant saturable est un absorbant à semi-conducteurs.

6. Dispositif selon l'une quelconque des revendications précédentes, **caractérisé en ce qu'**il comprend un dispositif interférométrique (17) placé en sortie de l'échantillonneur optique (Ech) pour réduire la largeur des échantillons optiques (Ei).

7. Dispositif selon la revendication 6, **caractérisé en ce que** le dispositif interférométrique (17) comprend :

- un séparateur équilibré (18) qui divise un échantillon optique en un premier sous-échantillon et en un second sous-échantillon,
- un premier bras qui comprend un premier miroir (21), un deuxième miroir (23) et un circuit de retard (22) placé entre le premier miroir et le deuxième miroir pour constituer un premier trajet optique pour les premiers sous-échantillons,
- un deuxième bras qui comprend un circuit à retard ajustable par polarisation externe (19) et polarisé à une tension (Vb) sensiblement égale à une tension demi-onde pour constituer un deuxième trajet optique pour les seconds sous-échantillons, et
- un combineur (20) pour combiner les premiers et seconds sous-échantillons qui se propagent respectivement sur les premier et deuxième bras.

8. Dispositif selon l'une quelconque des revendications précédentes, **caractérisé en ce que** les moyens de réplication (1, F) comprennent un coupleur à quatre ports (a, b, c, d) , le coupleur à quatre ports ayant deux ports d'entrée (a, d) et deux ports de sortie (b, c), un premier port d'entrée (a) constituant l'entrée par laquelle l'impulsion optique initiale pénètre dans le dispositif de mesure et un premier port de sortie (b) constituant une sortie par laquelle les impulsions répliques sont délivrées, la fibre optique(F) reliant le deuxième port de sortie (c) au deuxième port d'entrée (d).

9. Dispositif selon la revendication 8, **caractérisé en ce que** les moyens d'asservissement (2, 3, 4) comprennent, outre ledit amplificateur (AMP), un coupleur à trois ports (2) dont un port d'entrée (e) est relié à la sortie par laquelle les impulsions répliques sont délivrées, un circuit de commande (3) et un atténuateur (4) placés en série avec ledit amplificateur sur la fibre optique(F), le coupleur à trois ports (2) permettant de prélever une fraction d'impulsion réplique pour transmettre ladite fraction d'impulsion réplique au circuit de commande (3) qui délivre un signal de commande (Cg) fonction de l'amplitude de la fraction d'impulsion réplique prélevée, le signal de commande (Cg) étant appliqué comme une commande électrique sur l'atténuateur (4).

10. Dispositif selon la revendication 8 ou 9, **caractérisé en ce que** la fibre optique (F) est une fibre monomode.

11. Dispositif selon la revendication 10, **caractérisé en ce que** lesdits moyens de réplication comprennent un compensateur de dispersion (15) monté en série sur la fibre monomode (F).

12. Dispositif selon la revendication 11, **caractérisé en ce que** le compensateur (15) est un réseau de Bragg de pas spatialement variable.

13. Dispositif selon la revendication 11, **caractérisé en ce que** le compensateur (15) est un morceau de fibre dont le coefficient de dispersion est opposé au coefficient de dispersion des autres composants desdits moyens de réplication.

14. Dispositif selon la revendication 9, **caractérisé en ce que** le coupleur à quatre ports (1), la fibre optique, le coupleur à trois ports (2), l'atténuateur (4), l'amplificateur (AMP) et le diviseur (5) sont intégrés sur un substrat semi-conducteur à guides d'ondes implantés.

15. Dispositif selon la revendication 14, **caractérisé en ce que** lesdits moyens de réplication comprennent un compensateur de dispersion (15) constitué d'un réseau de Bragg implanté en série sur la fibre optique.

16. Dispositif selon l'une quelconque des revendications précédentes, **caractérisé en ce qu'**il comprend une fenêtre optique (16) placée sur le trajet des impulsions laser (IL), entre la source d'impulsions laser (7) et l'échantillonneur optique (Ech).

17. Dispositif selon l'une quelconque des revendications précédentes, **caractérisé en ce que** les moyens de détection (D, CN) comprennent au moins une photodiode (D) en série avec un convertisseur analogique/numérique (CN).

18. Dispositif selon la revendication 17, **caractérisé en ce que** le convertisseur analogique/numérique (CN) est un convertisseur sur 8 ou 10 bits.

19. Dispositif selon l'une quelconque des revendications 19 ou 20, **caractérisé en ce qu'**il comprend une mémoire (M) qui stocke les signaux délivrés par le convertisseur analogique/numérique (CN).

20. Dispositif selon l'une quelconque des revendications précédentes, **caractérisé en ce que** la source d'impulsions laser (7) est une source à blocage de modes.

21. Dispositif de mesure de profil d'impulsions électriques monocoup ou à faible taux de répétition, **caractérisé en ce qu'**il comprend un modulateur électro-optique en série avec un dispositif de mesure de profil d'impulsions optiques selon l'une quelconque des revendications 1 à 20.

22. Dispositif de mesure d'impulsion électrique monocoup selon la revendication 21, **caractérisé en ce que** le modulateur électro-optique est un modulateur à modulation indirecte.

23. Dispositif de mesure d'impulsion électrique monocoup selon la revendication 21, **caractérisé en ce que** le modulateur électro-optique est un modulateur à modulation directe.

24. Dispositif de mesure d'impulsion électrique monocoup selon la revendication 23, **caractérisé en ce que** le modulateur électro-optique est une diode.

**Claims**

1. Device for measuring the profile of very short single optical pulses or pulses with a low repetition rate, comprising replication means (1, F) for creating a series of replica pulses (Ri) of the initial optical pulse, with period τ starting from an initial optical pulse (I), slaving means (2, 3, 4) for adjusting the amplitudes of replica pulses (Ri) to values approximately the same as each other, means (7, Ech) of sampling replica pulses (Ri) to output optical samples (Ei) starting from the replica pulses (Ri), and detection means (D) to form an electrical signal from optical samples (Ei) output by sampling means (7, Ech), the optical sampling means comprising a laser source (7) that emits laser pulses (IL) with a frequency 1/To and with a very much shorter duration ($T_{ML}$) than the initial optical pulse, the period τ of the replica pulses and the period To of the laser pulses being related by the relation:

$$\tau = \text{To} - \delta t,$$

where
δt is a time drift with a very significantly shorter duration than the initial optical pulse duration, and an optical sampler (Ech) illuminated by the replica pulses (Ri) and by the laser pulses (IL), said device being **characterised in that** said replication means comprise an optical fibre loop and an amplifier (AMP) in said loop, said optical sampler (Ech) comprises a divider (5) to divide a replica pulse (Ri) into a first replica pulse fraction (Ia) and a second replica pulse fraction (Ib), a saturable absorbent (6) comprising a first zone (Z1) and a second zone (Z2), illuminated by the first and second replica pulse fractions respectively, the first zone (Z1) being made approximately transparent under the effect of laser pulses (IL), and an interferometric optical subtraction device (DISO) that outputs an optical sample (Ei) as the result of the difference between a sampled signal output from the first saturable absorbent zone (Z1) and a signal output from the second saturable absorbent zone (Z2).

2. Device according to claim 1, **characterised in that** the interferometric optical subtraction device (DISO) comprises a first arm (B1) with an input to collect the sampled signal output from the first zone (Z1, a second arm (B2) to collect the signal output from the second zone (Z2), a phase shifter (Dph), installed in series on the second arm in order to set a phase shift Π between the optical signal output from the first arm (B1) and the optical signal output from the second arm (B2), and a junction (J) with two inputs and one output that collects the signal output from the first arm (B1) on a first input and the signal output from the second arm (B2) on a second input, and that outputs the optical sample (Ei) on its output.

3. Device according to either claim 1 or 2, **characterised in that** the saturable absorbent is a colouring agent-based liquid solution.

4. Device according to either claim 1 or 2, **characterised in that** the saturable absorbent comprises carbon nano tubes.

5. Device according to either claim 1 or 2, **characterised in that** the saturable absorbent is an absorbent with semi-conductors.

6. Device according to any one of the previous claims, **characterised in that** it comprises an interferometric device (17) installed at the output from the optical sampler (Ech) to reduce the width of the optical samples (Ei).

7. Device according to claim 6, **characterised in that** the interferometric device (17) comprises:

   - a balanced separator (18) which divides an optical sample into a first sub-sample and a second sub-sample,
   - a first arm which comprises a first mirror (21), a second mirror (23) and a delay circuit (22) located between the first mirror and the second mirror to form a first optical path for the first sub-samples;
   - a second arm which comprises an adjustable delay circuit (19) by external polarisation and polarised to a polarisation voltage (Vb) substantially equal to a half-wave voltage to form a second optical path for the second sub-samples, and
   - a combiner (20) to combine the first and second sub-samples which propagate on the first and the second arms respectively.

8. Device according to any one of the previous claims, **characterised in that** the replication means (1, F) comprise a four-port coupler (a, b, c, d), the four-port coupler comprising two input ports (a, d) and two output ports (b, c), a first input port (a) forming the input through which the initial optical pulse enters the measurement device and a first output port (b) forming the output through which replica pulses are output, the optical fibre (F) connecting the second output port (c) to the second input port (d).

9. Device according to claim 8, **characterised in that** the slaving means (2, 3, 4) comprise, in addition to said amplifier (AMP), a three-port coupler (2) of which one input port (e) is connected to the output through which the replica pulses are output, a control circuit (3), an amplifier (AMP), and an attenuator (4), installed in series with said amplifier on the fibre guide (F), the three-port coupler (2) enabling sampling of a replica pulse fraction to transmit the said replica pulse fraction to the control circuit (3) which delivers a control signal (Cg) depending on the amplitude of the replica pulse fraction sampled, the control signal (Cg) being applied to the attenuator (4) in the same way as for an electrical control.

10. Device according to claim 8 or 9,
 **characterised in that** the optical fibre (F) is a single-mode fibre.

11. Device according to claim 10, **characterised in that** said replication means comprise a dispersion compensator (15) installed in series on the single-mode fibre (F).

12. Device according to claim 11, **characterised in that** the compensator (15) is a chirped Bragg network.

13. Device according to claim 11, **characterised in that** the compensator (15) is a fibre segment for which the dispersion coefficient is opposed to the dispersion coefficient of the other components of said replication means.

14. Device according to claim 9, **characterised in that** the four-port coupler (1), the optical fibre, the three-port coupler (2), the attenuator (4), the amplifier (AMP) and the divider (5) are integrated on a semi-conducting substrate with implanted wave guides.

15. Device according to claim 14, **characterised in that** it comprises a dispersion compensator (15) formed from a Bragg network implanted in series on the wave guide.

16. Device according to any one of the previous claims, **characterised in that** it comprises an optical window (16) located on the path of the laser pulses (IL), between the laser pulse source (7) and the optical sampler (Ech).

17. Device according to any one of the previous claims, **characterised in that** the detection means (D, CN) comprise at least a photodiode (D) in series with an analogue/digital converter (CN).

18. Device according to claim 17, **characterised in that** the analogue/digital converter (CN) is a converter on 8 or 10 bits.

19. Device according to either claim 17 or 18, **characterised in that** it comprises a memory (M) which stores the signals output by the analogue/digital converter (CN).

20. Device according to any one of the previous claims, **characterised in that** the laser pulse source (7) is a mode blocking source.

21. Device for measuring the profile of single electrical pulses or pulses with a low repetition rate, **characterised in that** it comprises an electro-optical modulator in series with a device for measuring the profile of optical pulses according to any one of claims 1 to 20.

22. Device for measuring single electrical pulses according to claim 21, **characterised in that** the electro-optical modulator is an indirect modulation modulator.

23. Device for measuring single electrical pulses according to claim 21, **characterised in that** the electro-optical modulator is a direct modulation modulator.

24. Device for measuring single electrical pulses according to claim 23, **characterised in that** the electro-optical modulator is a diode.

**Patentansprüche**

1. Messvorrichtung des Profils optischer Impulse des Typs Monoimpuls oder mit niedriger Wiederholungsrate, umfassend

Replikationseinrichtungen (1, F), um aufgrund eines optischen Initialimpulses (I) eine Serie von Replikationsimpulsen (Ri) des optischen Initialimpulses mit der Periode τ zu erzeugen, Regeleinrichtungen (2, 3, 4), um die Amplituden der Replikationsimpulse (Ri) auf im Wesentlichen untereinander identische Werte zu regeln, Abtasteinrichungen (7, Ech) der Replikationsimpulse (Ri), um aufgrund der Replikationsimpulse (Ri) optische Samples (Ei) zu liefern, und Detektionseinrichtungen (D), um aufgrund der durch die Abtasteinrichtungen (7, Ech) gelieferten optischen Samples (Ei) ein elektrisches Signal zu formen, wobei die Abtasteinrichtungen eine Laserquelle (7) umfassen, fähig Laserimpulse (IL) mit der Frequenz 1/To und einer Dauer ($T_{ML}$) zu senden, die sehr viel kürzer ist als die Dauer des optischen Initialimpulses, und die Periode τ der Replikationsimpulse und die Periode To der Laserimpulse durch folgende Relation verknüpft sind:

$$\tau = To - \delta t$$

wo δt ein zeitliches Gleiten von einer sehr viel kürzeren Dauer als der Dauer des optischen Initialimpulses ist, und einen optischen Abtaster (Ech), belichtet durch die Replikationsimpulse (Ri) und durch die Laserimpulse (IL), wobei die Vorrichtung **dadurch gekennzeichnet ist, dass**

die genannten Replikationseinrichtungen eine Schleife in Form einer optischen Faser und in der Schleife einen Verstärker (AMP) umfassen,

der genannte optische Abtaster (Ech) einen Teiler (5) umfasst, um einen Replikationsimpuls (Ri) in einen ersten Replikationsimpulsteil (Ia) und einen zweiten Replikationsimpulsteil (Ib) zu teilen, wobei ein sättigbares Absorptionsmittel (6), eine erste Zone (Z1) und eine zweite Zone (Z2) umfassend, jeweils durch den ersten und den zweiten Replikationsimpulsteil belichtet wird und die erste Zone dabei unter der Wirkung der Laserimpulse (IL) im Wesentlichen transparent gemacht wird, und eine optische interferometrische Subtraktionsvorrichtung (DISO) umfasst, fähig als Resultat der

Differenz zwischen einem am Ausgang der ersten Zone (Z1) gelieferten abgetasteten Signal und einem am Ausgang der zweiten Zone (Z2) gelieferten Signal ein optisches Sample (Ei) zu liefern.

2. Vorrichtung nach Anspruch 1, **dadurch gekennzeichnet, dass** die optische interferometrische Subtraktionsvorrichtung (DISO) umfasst: einen ersten Arm (B1) mit einem Eingang für den Empfang des am Ausgang der ersten Zone (Z1) gelieferten abgetasteten Signals, einen zweiten Arm (B2) für den Empfang des am Ausgang der zweiten Zone (Z2) gelieferten Signals, einen Phasenschieber (Dph), in dem zweiten Arm in Serie geschaltet, um eine Phasenverschiebung von π zwischen dem am Ausgang des ersten Arms (B1) gelieferten optischen Signal und dem am Ausgang des zweiten Arms (B2) gelieferten Signal zu realisieren, und eine Verzweigung (J) mit zwei Eingängen und einem Ausgang, die an einem ersten Eingang das am Ausgang des ersten Arms (B1) gelieferte Signal und an einem zweiten Eingang das am Ausgang des zweiten Arms (B2) gelieferte Signal aufnimmt und an ihrem Ausgang das optische Sample (Ei) liefert.

3. Vorrichtung nach einem der Anspruch 1 oder 2, **dadurch gekennzeichnet, dass** das sättigbare Absorptionsmittel eine flüssige Lösung auf der Basis von Farbstoffen ist.

4. Vorrichtung nach einem der Anspruch 1 oder 2, **dadurch gekennzeichnet, dass** das sättigbare Absorptionsmittel Kohlenstoff-Nanoröhrchen umfasst.

5. Vorrichtung nach einem der Anspruch 1 oder 2, **dadurch gekennzeichnet, dass** das sättigbare Absorptionsmittel ein Halbleiter-Absorptionsmittel ist.

6. Vorrichtung nach einem der vorangehenden Ansprüche, **dadurch gekennzeichnet, dass** sie eine am Ausgang des optischen Abtasters (Ech) befindliche interferometrische Vorrichtung (17) umfasst, um die Breite der optischen Samples (Ei) zu reduzieren.

7. Vorrichtung nach Anspruch 6, **dadurch gekennzeichnet, dass** die interferometrische Vorrichtung (17) umfasst:

- einen abgeglichenen Separator (18), der ein optisches Sample in ein erstes Teilsample und ein zweites Teilsample teilt,

- einen ersten Arm, der einen ersten Spiegel (21), einen zweiten Spiegel (23) und eine Verzögerungsschaltung (22) umfasst, die sich zwischen dem ersten Spiegel und dem zweiten Spiegel befindet, um für die ersten Teilsamples einen ersten optischen Weg zu bilden,

- einen zweiten Arm, der eine durch externe Polarisation justierbare und mit einer Spannung (Vb) im Wesentlichen gleich einer Halbwellenspannung polarisierbare Verzögerungsschaltung (19) umfasst, um für die zweiten Teilsamples einen zweiten optischen Weg zu bilden, und

- einen Combiner (20), um die ersten und zweiten Teilsamples, die sich jeweils in dem ersten Arm und dem zweiten Arm ausbreiten, zu kombinieren.

8. Vorrichtung nach einem der vorangehenden Ansprüche, **dadurch gekennzeichnet, dass** die Einrichtungen (1, F) zur Erzeugung einer Serie von Replikationsimpulsen des optischen Initialimpulses einen Koppler mit vier Anschlüssen (a, b, c, d) und einen Wellenleiter (F) umfassen, wobei der Koppler mit 4 Anschlüssen zwei Eingangsanschlüsse (a, d) und zwei Ausgangsanschlüsse (b, c) hat, ein erster Eingangsanschluss (a) den Eingang bildet, durch den der optische Initialimpuls in die Messvorrichtung eindringt, und ein erster Ausgangsanschluss (b) einen Ausgang bildet, durch den die Replikationsimpulse geliefert werden, wobei die optische Faser (F) den zweiten Ausgangsanschluss (c) mit dem zweiten Eingangsanschluss (d) verbindet.

9. Vorrichtung nach Anspruch 8, **dadurch gekennzeichnet, dass** die Regeleinrichtungen (2, 3, 4) außer dem genannten Verstärker (AMP) umfasst: einen Koppler mit drei Anschlüssen (2), dessen Eingangsanschluss (e) mit dem Ausgangsanschluss verbunden ist, der die Replikationsimpulse liefert, eine Steuerschaltung (3) und ein in der optischen Faser (F) mit dem genannten Verstärker in Serie geschaltetes Dämpfungsglied (4), wobei der Koppler mit drei Anschlüssen (2) ermöglicht, einen Replikationsimpulsteil zu entnehmen und diesen Replikationsimpulsteil zu der Steuerschaltung (3) zu übertragen, die ein Steuersignal (Cg), Funktion der Amplitude des entnommenen Replikationsimpulsteils, liefert, wobei das Steuersignal (Cg) als ein elektrischer Befehl an das Dämpfungsglied (4) angelegt wird.

10. Vorrichtung nach Anspruch 8 oder 9, **dadurch gekennzeichnet, dass** die optische Faser (F) eine Einmodenfaser ist.

11. Vorrichtung nach Anspruch 10, **dadurch gekennzeichnet, dass** die genannten Replikationseinrichtungen einen in der Einmodenfaser (15) in Serie geschalteten Dispersionskompensator (15) umfassen.

12. Vorrichtung nach Anspruch 11, **dadurch gekennzeichnet, dass** der Kompensator (15) ein Bragg-Gitter mit räumlich variabler Teilung bzw. Gitterperiode ist.

13. Vorrichtung nach Anspruch 11, **dadurch gekennzeichnet, dass** der Kompensator (15) ein Faserstück ist, dessen Disperionskoeffizient zu den Disperionskoeffizienten der anderen Baukomponenten der genannten Replikationseinrichtungen entgegengesetzt ist.

14. Vorrichtung nach Anspruch 9, **dadurch gekennzeichnet, dass** der Koppler mit vier Anschlüssen (1), die optische Faser, der Koppler mit drei Anschlüssen (2), das Dämpfungsglied (4), der Verstärker (AMP) und der Teiler (5) auf einem Halbleitersubstrat mit implantierten Wellenleitern integriert sind.

15. Vorrichtung nach Anspruch 14, **dadurch gekennzeichnet, dass** die genannten Replikationseinrichtungen einen Dispersionskompensator (15) umfassen, gebildet durch ein in Serie in die optische Faser integriertes Bragg-Gitter.

16. Vorrichtung nach einem der vorangehenden Ansprüche, **dadurch gekennzeichnet, dass** sie ein in dem Weg des Laserimpulses (IL) platziertes optisches Fenster (16) umfasst, zwischen der Laserimpulsquelle (7) und dem optischen Abtaster (Ech).

17. Vorrichtung nach einem der vorangehenden Ansprüche, **dadurch gekennzeichnet, dass** die Detektionseinrichtungen (D, CN) wenigstens eine Fotodiode (D) in Serie mit einem Analog/Digital-Wandler (CN) umfassen.

18. Vorrichtung nach Anspruch 17, **dadurch gekennzeichnet, dass** der Analog/Digital-Wandler (CN) ein 8- oder 10-Bit-Wandler ist.

19. Vorrichtung nach einem der Ansprüche 19 oder 20, **dadurch gekennzeichnet, dass** sie einen Speicher (M) umfasst, der die durch den Analog/Digital-Wandler (CN) gelieferten Signale speichert.

20. Vorrichtung nach einem der vorangehenden Ansprüche, **dadurch gekennzeichnet, dass** die Laserimpulsquelle (7) eine Modensperr- bzw. Modenunterdrückungsquelle ist.

21. Messvorrichtung des Profils elektrischer Impulse des Typs Monoimpuls oder mit niedriger Wiederholungsrate, **dadurch gekennzeichnet, dass** sie einen elektrooptischen Modulator in Serie mit einer Messvorrichtung des Profils optischer Impulse nach einem der Ansprüche 1 bis 20 umfasst.

22. Messvorrichtung elektrischer Monoimpulse nach Anspruch 21, **dadurch gekennzeichnet, dass** der elektrooptische Modulator ein Modulator mit indirekter Modulation ist.

23. Messvorrichtung elektrischer Monoimpulse nach Anspruch 21, **dadurch gekennzeichnet, dass** der elektrooptische Modulator ein Modulator mit direkter Modulation ist.

24. Messvorrichtung elektrischer Monoimpulse nach Anspruch 23, **dadurch gekennzeichnet, dass** der elektrooptische Modulator eine Diode ist.

FIG. 1

EP 1 782 027 B1

EP 1 782 027 B1

FIG. 2A

$T_{ML}$

$T_0$

t

FIG. 2B

R1

R2

R3

RN

$T1$         $T1 + \delta t$         $T1 + 2.\delta t$         $T1 + (N-1)\delta t$

t

FIG. 2C

FIG. 2D

IL

P1        K        P2

Ri

Ei

Ech

# FIG. 3

$I_E$

I

24

25

# FIG. 11

FIG. 4

FIG.5A

FIG.5B

FIG.5C

FIG. 6

EP 1 782 027 B1

FIG. 7

FIG. 8A

FIG. 8B

FIG. 9

EP 1 782 027 B1

FIG. 10

EP 1 782 027 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DENG K-L.** Single-shot optical sampling oscilloscope for ultrafast optical waveforms. *IEEE Photonics Technology Letters,* Mars 1998, vol. 10 (3), 397-399